# EUROPÄISCHE PATENTSCHRIFT

(11) **EP 0 505 842 B1**
(45) Veröffentlichungstag und Bekanntmachung des Hinweises auf die Patenterteilung: **06.09.1995**
(21) Anmeldenummer: 92104261.0
(22) Anmeldetag: 12.03.1992
(51) Int. Cl.: H01S 3/025, H01L 33/00, H01L 23/66

(54) **Einrichtung mit einem Trägerteil, einem Halbleiterlaser und Zuleitungen**
Arrangement with a support, a semi-conductor laser and leads
Arrangement avec un support, un laser à sémi-conducteur et des conducteurs

(30) Priorität: 28.03.1991 DE 4110378
(43) Veröffentlichungstag der Anmeldung: 30.09.1992
(73) Patentinhaber: Alcatel SEL Aktiengesellschaft, D-70435 Stuttgart (DE); ALCATEL N.V., NL-1077 XX Amsterdam (NL)
(72) Erfinder: Mayer, Hans-Peter, W-7015 Korntal (DE); Luz, Gerhard, W-7120 Bietigheim-Bissingen (DE)
(74) Vertreter: Pohl, Herbert, Dipl.-Ing.

(56) Entgegenhaltungen:
- EP-A- 0 375 231
- WO-A-87/02834
- DE-A- 3 902 579
- PATENT ABSTRACTS OF JAPAN vol. 12, no. 135 (E-604)23. April 1988 &JP-A-62 260385
- PATENT ABSTRACTS OF JAPAN vol. 15, no. 3 (E-1019)7. Januar 1991 &JP-A-2 257 690

## Beschreibung

Die Erfindung bezieht sich auf eine Einrichtung mit einem Trägerteil, einem Halbleiterlaser und Zuleitungen nach dem Oberbegriff des Patentanspruchs 1. Eine derartige Einrichtung ist aus JP-A-62 260 385 bekannt.

Für die optische Nachrichtenübertragung über Lichtwellenleiter werden optoelektronische Wandlermodule als Sende- oder Empfangsmodule benötigt. Die Wandlermodule enthalten neben anderen elektrischen Bestandteilen insbesondere eine Einrichtung mit einem entweder als Sender oder als Empfänger dienenden Halbleiterlaser, der auf der Oberseite eines Trägerteils aufgebracht ist. Als elektrische Anschlüsse für den Halbleiterlaser dienen Zuleitungen, die ebenfalls auf dem Trägerteil aufgebracht sind.

Aus der DE-A1-40 13 630 ist eine derartige Einrichtung mit einem Trägerteil, einem Halbleiterlaser und Zuleitungen bekannt. Das Trägerteil besteht aus Silizium. Der Halbleiterlaser ist mit einer ersten Zuleitung unmittelbar, mit einer zweiten Zuleitung über einen Anschlußdraht verbunden. Diese Einrichtung hat den Nachteil, daß sie sich für die optische Nachrichtenübertragung höchstens bis zum MHz-Bereich eignet.

Es ist die Aufgabe der Erfindung, eine Einrichtung mit einem Trägerteil, einem Halbleiterlaser und Zuleitungen zu schaffen, die für die optische Nachrichtenübertragung im Höchstfrequenzbereich geeignet ist.

Die Aufgabe wird erfindungsgemäß durch eine Einrichtung mit den Merkmalen des Patentanspruchs 1 gelöst.

Ausgestaltungen der Erfindung sind den Unteransprüchen zu entnehmen.

Anstelle von Silizium wird erfindungsgemäß eine Keramik für das Trägerteil eingesetzt. Keramiken, z.B. Aluminiumoxid-(Al₂O₃)-Keramik, haben gegenüber Silizium den Vorzug eines viel höheren spezifischen elektrischen Widerstandes. So ist der spezifische Widerstand von Aluminiumoxid-Keramik gegenüber undotiertem, d.h. semiisolierendem Silizium mindestens um den Faktor 10⁸ höher. Gegenüber semiisolierendem Galliumarsenid ist er wenigstens um den Faktor 10⁴ höher. Aufgrund der geringeren spezifischen Widerstände weisen Silizium und Galliumarsenid als Substrate für Zuleitungen hohe Ableitungsverluste auf, wenn sich in den Zuleitungen elektrische Hoch- oder Höchstfrequenzsignale ausbreiten.

Durch die Verwendung eines Trägerteils aus Keramik wird ein anderer Nachteil des Siliziums vermieden, der darin besteht, daß eine bei der Herstellung erzielte Reinheit des Trägerteils bei nachfolgenden Prozessen zur Herstellung der Zuleitungen wieder verlorengeht.

So wird bei Hochtemperatur-Diffusionsprozessen oder der Herstellung von Schichten in einer Vakuum-Bedampfungsanlage das Silizium mit Verunreinigungen angereichert, wodurch der spezifische Widerstand sinkt.

Im Gegensatz dazu sind für das Trägerteil besonders Keramiken aus Aluminiumnitrid und Bornitrid geeignet. Beide Materialien haben eine hohe thermische Leitfähigkeit. Darüber hinaus hat Aluminiumnitrid eine Wärmeausdehnung, die ungefähr der des Substrats (Indiumphosphid) des Halbleiterlasers entspricht.

Gemäß einer Ausgestaltung der Erfindung ist der Halbleiterlaser an der Kante der Oberfläche des Trägerteils so aufgebracht, daß kein Anteil des von dem Halbleiterlaser abgestrahlten Sendelichts von der Oberfläche des Trägerteils absorbiert oder von ihr reflektiert wird. Vielmehr ist aufgrund der erfindungsgemäßen Anbringung des Halbleiterlasers eine einfache Justierung eines Lichtwellenleiters auf den Strahl des Sendelichts möglich.

Bei einem bevorzugten Ausführungsbeispiel sind die Mikrostreifenleitungen durch ohmsche Widerstände abgeschlossen, die den Wellenwiderständen der Mikrostreifenleitungen angepaßt sind. Die ohmschen Widerstände sind dabei auf dem Trägerteil entfernt von dem Halbleiterlaser angebracht, um zu vermeiden, daß der Halbleiterlaser durch die von den Widerständen erzeugte Wärme zusätzlich aufgeheizt wird.

Einem weiteren bevorzugten Ausführungsbeispiel zufolge werden dem Halbleiterlaser ein Gleichstrom und ein sich aus den elektrischen Hochfrequenzsignalen zusammensetzender Wechselstrom über getrennte Leitungen zugeführt. Dies hat den Vorteil, daß die Leitungen der Art des Stromes speziell anpaßbar sind und ein Abschlußwiderstand vom Gleichstrom entlastet ist.

Die erfindungsgemäße Einrichtung ist für Hochfrequenzsignale mit einer Frequenz von mehr als 20 GHz geeignet.

Die übrigen Unteransprüche sind weitere zweckmäßige Ausbildungen der Erfindung.

Nachstehend wird die Erfindung in Ausführungsbeispielen anhand von Zeichnungen erläutert. Es zeigen:
- Fig. 1: eine Draufsicht auf eine erste Einrichtung mit einem Halbleiterlaser und Mikrostreifenleitungen, die auf der Oberseite eines Trägerteils aufgebracht sind,
- Fig. 2: eine durch eine Mikrostreifenleitung gebildete Spule,
- Fig. 3: eine Seitenansicht der ersten Einrichtung und
- Fig. 4: eine Draufsicht auf eine zweite Einrichtung mit für Gleichstrom und Wechselstrom getrennten Zuleitungen.

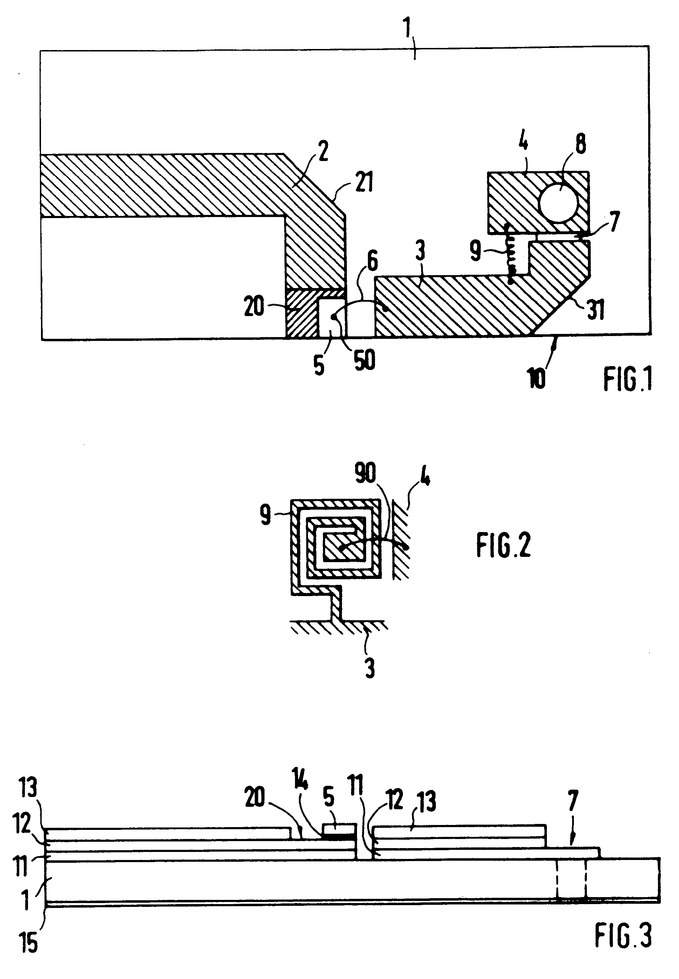

Fig. 1 zeigt die erste Einrichtung mit einem Trägerteil, das aus einer Keramik, z.B. aus Aluminiumnitrid (AlN) oder Bornitrid (BN), besteht und die Form eines Blocks 1 hat. Auf ihm sind als Zuleitungen Mikrostreifenleitungen 2, 3 und 4 vorhanden. Die Mikrostreifenleitung 2 dient einem Halbleiterlaser 5 als Zuführung für Hochfrequenzsignale, die einem Gleichstrom überlagert sind. Der Halbleiterlaser 5 wird durch den Gleichstrom betrieben und durch die Hochfrequenzsignale moduliert. Der Halbleiterlaser 5 ist auf einen Bereich 20 der Mikrostreifenleitung 2 aufgelötet. Hierfür ist seine Unterseite metallisiert, die als elektrischer Kontakt zu dem Bereich 20 der Mikrostreifenleitung 2 dient. Auf seiner Oberseite weist der Halbleiterlaser einen weiteren elektrischen Kontakt 50 auf, der über einen Bonddraht 6 mit der Mikrostreifenleitung 3 verbunden ist, welche zusammen mit dem ihr in Übertragungsrichtung der Hochfrequenzsigale nachfolgenden elektrischen Bauelementen der Abführung der Hochfrequenzsignale zu einem Massekontakt dient. Über einen ohmschen Widerstand 7 ist die Mikrostreifenleitung 3 mit der Mikrostreifenleitung 4 verbunden. Diese bildet die Umrandung einer Bohrung 8, die auf ihrer zylindrischen Innenwand elektrisch leitend plattiert ist.

Die Mikrostreifenleitungen 2, 3 weisen einen kompensierten Knick 21 bzw. 31 auf, um die Reflexion der Hochfrequenzsignale gering zu halten. Derartige kompensierte Knicke 21, 31 sind in Mikrowellenschaltungen üblich und beispielsweise aus R.K. Hoffmann, Integrierte Mikrowellenschaltungen; Berlin, Heidelberg, New York, Tokyo (1983), S. 97 bekannt.

Die Mikrostreifenleitung 2 hat beispielsweise einen Wellenwiderstand von 50 Ω. Sie sollte daher durch einen ohmschen Widerstand von 50 Ω abgeschlossen werden. Wenn jedoch zwischen der Mikrostreifenleitung 2 und dem Halbleiterlaser 5 ein ohmscher Widerstand angebracht wäre, würde dieser durch die in ihm entstehende Wärme die Eigenschaften des Halbleiterlasers 5 beeinflussen.

Da der Halbleiterlaser 5 jedoch beispielsweise einen ohmschen Widerstand von 5 Ω darstellt, muß die in Übertragungsrichtung der Hochfrequenzsignale hinter ihm liegende Mikrostreifenleitung 3 einen Wellenwiderstand von 45 Ω aufweisen, damit sie zusammen mit dem Halbleiterlaser 5 einen 50 Ω-Abschlußwiderstand für die Mikrostreifenleitung 2 bildet.

Da die Mikrostreifenleitung 3 nun einen Wellenwiderstand von 45 Ω hat, benötigt sie einen ohmschen Abschlußwiderstand von ebenfalls 45 Ω; dies ist der Widerstand 7.

Der Halbleiterlaser 5 ist auf dem Block 1 so angeordnet, daß er mit einer Seitenkante 10 des Blocks 1 abschließt. Aus der auf der Seitenkante 10 liegenden Querseite des Halbleiterlasers 5 wird das von ihm erzeugte Sendelicht abgestrahlt.

Anstelle des einzigen Bonddrahtes 6 können auch mehrere Bonddrähte zur Verbindung zwischen dem Halbleiterlaser 5 und der Mikrostreifenleitung 3 vorhanden sein. Da ein Bonddraht als elektrisches Bauelement im wesentlichen eine Induktivität bedeutet, läßt sich diese verringern, wenn mehrere Bonddrähte die Verbindung zwischen dem Halbleiterlaser 5 und der Mikrostreifenleitung 3 bilden. Von dieser lassen sich der Gleichstromanteil und die Hochfrequenzsignale getrennt auf die Mikrostreifenleitung 4 abführen. Daher ist parallel zu dem Widerstand 7 ein induktives Bauelement 9 vorgesehen, welches hier zur Vereinfachung als eine durch einen Draht gebildete Spule dargestellt ist.

Vorzugsweise besteht das Bauelement 9 (Fig. 2) aus einer Spirale gebildet, die einerseits mit der Mikrostreifenleitung 3 und andererseits über einen Bonddraht 90 mit der Mikrostreifenleitung 4 verbunden ist. In diesem Fall ist das Bauelement 9 entweder als Mikrostreifenleitung oder in Form einer anderen Zuleitung ausgebildet.

In Fig. 3 ist der Schichtenaufbau auf dem Block 1 schematisch (nicht maßstabsgetreu) dargestellt. Die Mikrostreifenleitungen 2 - 4 bestehen jeweils aus drei übereinanderliegenden Schichten: einer Haftschicht 11, einer Lötschicht 12 und einer Schutzschicht 13. Die Haftschicht 11 besteht aus einer Nickel-Chrom-Legierung, die Lötschicht 12 aus Nickel und die Schutzschicht 13 aus Gold.

Die Haftschicht 11 und die Lötschicht 12 werden vorzugsweise auf den Block 1 aufgedampft, die Schutzschicht 13 galvanisch aufgebracht. In dem Bereich 20 sind ausschließlich die Haftschicht 11 und die Lötschicht 12 vorhanden. Auf dieser ist in einem Teil des Bereichs 20 eine Gold und Zinn enthaltende Schichtenfolge 14 aufgebracht; auf der der Halbleiterlaser 5 angeordnet ist.

Der ohmsche Widerstand 7 wird dadurch gebildet, daß dort als einzige Schicht die Haftschicht 11 vorhanden ist. Auf seiner Unterseite wird der Block 1 von einer als Massekontakt dienenden Schicht 15 bedeckt. Die Innenwand der Bohrung 8 (in Fig. 3 nicht dargestellt) wird ebenfalls durch die Haftschicht 11, die Lötschicht 12 und die Schutzschicht 13 bedeckt.

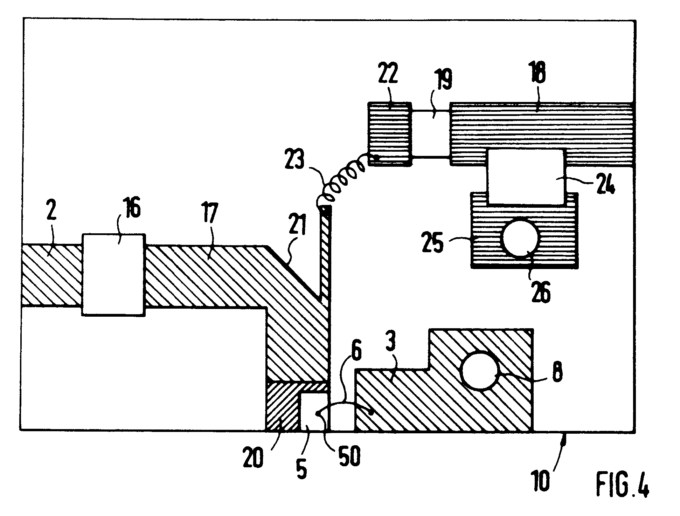

In einer zweiten, in Fig. 4 dargestellten Einrichtung sind die Zuführungen für den Gleichstrom und den Wechselstrom voneinander getrennt. Über die Mikrostreifenleitung 2 werden die Hochfrequenzsignale über einen Kondensator 16, eine Mikrostreifenleitung 17 und den Bereich 20 der Mikrostreifenleitung 2 dem Halbleiterlaser 5 zugeführt. Der Kondensator 16 dient zur elektrischen Trennung des Gleichstromanteils von der Mikrostreifenleitung 2. Der Gleichstromanteil wird über eine Leitung 18, einen ohmschen Widerstand 19, eine Leitung 22, ein induktives Bauelement 23 sowie die Mikrostreifenleitung 17 und den Bereich 20 dem Halbleiterlaser 5 zugeführt. Das induktive Bauelement 23 ist vorzugsweise so ausgeführt, wie in Fig. 2 dargestellt.

Das induktive Bauelement 23 gewährleistet, daß höchstens ein geringer Anteil der Hochfrequenzsignale auf die Leitungen 18, 22 gelangt. Eine RC-Kombination aus dem Widerstand 19 und einem Kondensator 24 gestattet die Abführung auch dieses Anteils über eine Leitung 25 und eine auf ihrer Innenwand leitend plattierte Bohrung 26 auf die Schicht 15 (vgl. Fig. 3) auf der Unterseite des Blocks 1. Die Kondensatoren 16, 24 sind vorzugsweise als Streifenleitungskondensatoren ausgebildet.

Während die Zuleitungen für den Halbleiterlaser 5 für den Gleich- und den Wechselstromanteil getrennt sind, ist die Verbindung zum Massekontakt, d.h. der Schicht 15, für beide Ströme über den Bonddraht 6, die Mikrostreifenleitung 3 und die Bohrung 8 gemeinsam.

Es ist auch möglich, die Gleichstrom- und die Wechselstromquelle, die den Gleichstrom- bzw. den Wechselstromanteil erzeugen, auf dem Block hybrid zu integrieren.

## Patentansprüche

1. Einrichtung mit einem aus Keramik bestehenden Trägerteil (1), auf dessen Oberseite ein Halbleiterlaser (5) und als Mikrosteifenleitungen (2 - 4) ausgebildete Zuleitungen aufgebracht sind, **dadurch gekennzeichnet**, daß die Zuleitungen jeweils aus mehreren übereinander liegenden Metallschichten bestehen, von denen eine als Haftschicht (11), eine als elektrische Leitschicht (12) und eine weitere als Schutzschicht (13) dient, und daß wenigstens zwei Mikrostreifenleitungen (z.B. 3, 4) durch einen ohmschen Widerstand (7) miteinander verbunden sind, der ausschließlich aus der Haftschicht besteht.

2. Einrichtung nach Anspruch 1, dadurch gekennzeichnet, daß der ohmsche Widerstand (7) dem Wellenwiderstand einer dem Halbleiterlaser (5) als Zuleitung dienenden Mikrostreifenleitung (z.B. 3) angepaßt und an dem vom Halbleiterlaser (5) entfernten Ende der Mikrostreifenleitung (z.B. 3) angeordnet ist.

3. Einrichtung nach Anspruch 1 oder 2, dadurch gekennzeichnet, daß das Trägerteil (1) für die Zuführung von Gleichstrom und für die Zuführung eines aus Hochfrequenzsignalen zusammengesetzten Wechselstroms zum Halbleiterlaser (5) getrennte Leitungen (18, 22, 17 und 2, 17) hat.

## Claims

1. Device having a support (1) consisting of ceramic, on whose upper side are placed a semiconductor laser (5) and supply leads constructed as micro-striplines (2 - 4), characterised in that each of the supply leads consists of several metal layers lying one above the other, of which one acts as an adhesive layer (11), one as an electrically conductive layer (12) and a further one as a protective layer (13), and that at least two micro-striplines (e.g. 3, 4) are interconnected via an ohmic resistance (7) that consists exclusively of the adhesive layer.

2. Device according to Claim 1, characterised in that the ohmic resistance (7) is matched to the characteristic impedance of a micro-stripline (e.g. 3) acting as supply lead for the semiconductor laser (5) and which ohmic resistance (7) is arranged at the end of the micro-stripline (e.g. 3) which is remote from the semiconductor laser (5).

3. Device according to Claim 1 or 2, characterised in that the support (1) has separate lines (18, 22, 17 and 2, 17) for carrying direct current and for carrying an alternating current composed of high-frequency signals to the semiconductor laser (5).

## Revendications

1. Dispositif comportant un support (1) qui est constitué de céramique et sur la face supérieure duquel sont rapportés un laser à semiconducteur (5) et des conducteurs d'amenée conçus sous forme de lignes à microrubans (2 - 4),
caractérisé par le fait que les conducteurs d'amenée sont chacun constitués de plusieurs couches métalliques qui sont situées l'une au-dessus de l'autre et dont l'une sert de couche d'adhérence (11), l'une de couche électriquement conductrice (12) et une autre de couche de protection (13), et qu'au moins deux lignes à microrubans (par exemple 3, 4) sont réunies l'une à l'autre par une résistance ohmique (7) qui est exclusivement constituée de la couche d'adhérence.

2. Dispositif selon la revendication 1, caractérisé par le fait que la résistance ohmique (7) est adaptée à l'impédance d'une ligne à microrubans (par exemple 3) qui sert de conducteur d'amenée au laser à semiconducteur (5) et qu'elle est disposée à l'extrémité de la ligne à microrubans (par exemple 3) éloignée du laser à semiconducteur (5).

3. Dispositif selon la revendication 1 ou 2, caractérisé par le fait que le support (1) présente des lignes distinctes (18, 22, 17 et 2, 17) pour samener au laser à semiconducteur (5) un courant continu et un courant alternatif composé de signaux de haute fréquence.
